**Europäisches Patentamt**

**European Patent Office**

**Office européen des brevets**

(19)

(11) **EP 1 235 345 A2**

(12) **EUROPEAN PATENT APPLICATION**

(43) Date of publication:
**28.08.2002  Bulletin 2002/35**

(51) Int Cl.7: **H03F 3/191**

(21) Application number: **02090069.2**

(22) Date of filing: **22.02.2002**

(84) Designated Contracting States:
**AT BE CH CY DE DK ES FI FR GB GR IE IT LI LU MC NL PT SE TR**
Designated Extension States:
**AL LT LV MK RO SI**

(30) Priority: **23.02.2001  JP  2001048037**

(71) Applicant: **NEC CORPORATION**
**Tokyo (JP)**

(72) Inventor: **Hirayama, Tomohisa,**
**c/o NEC Corporation**
**Tokyo (JP)**

(74) Representative: **Patentanwälte Wenzel & Kalkoff**
**Grubesallee 26**
**22143 Hamburg (DE)**

(54) **Analog amplifier circuit**

(57)    An analog amplifier circuit having an amplifier, an input matching circuit thereof and an output matching circuit thereof, said input matching circuit and said output matching circuit comprising: a circuit portion which capacitively functions with respect to a first frequency and inductively functions with respect to a second frequency, so as to match with respect to both of said first frequency and second frequency.

# FIG. 1

EP 1 235 345 A2

**Description**

BACKGROUND OF THE INVENTION

1.Field of the Invention

The present invention relates to an analog amplifier circuit and, more particularly, to an amplifier circuit, which can be suitably applied to an amplifier circuit for a dual band.

2.Related Background Art

In an amplifier circuit to be used in a mobile terminal such as a mobile telephone or a personal handy phone system (abbreviated as "a PHS"), an impedance is normally converted by the use of a matching circuit connected to an amplifier in such a manner as to obtain an optimum noise figure, optimum gain, optimum efficiency or optimum distortion at a required frequency. An amplifier to be used at a dual band has been required for recent mobile telephone As described in the literature (for example, IEEE, Journal of Solid-State Circuit, Vol. 35, Aug., 2000, p. 1109), there has been proposed a dual band amplifier circuit in which a power amplifier having respective matching circuits for two frequencies is provided for switching the matching circuits according to a frequency that is used.

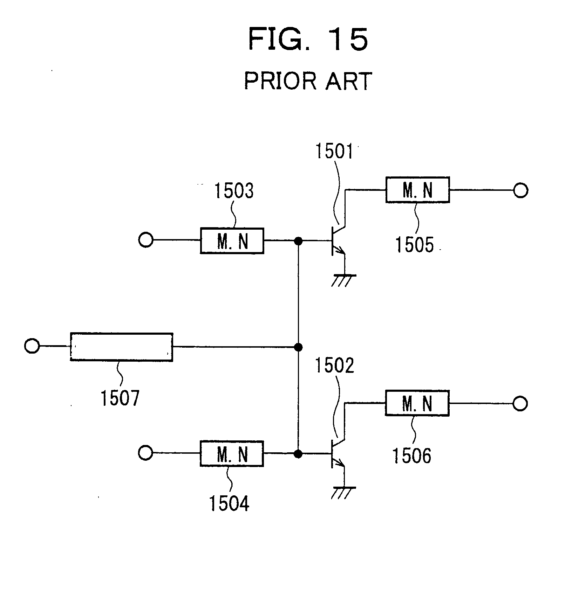

Fig. 15 is a circuit diagram illustrating the arrangement of a conventional dual band amplifier circuit, wherein

two amplifiers (i.e., transistors 1501 and 1502) which are matched according to frequencies, respectively, are provided in such a manner as to correspond to a dual band by switching the two amplifiers according to a frequency band to be used by means of a switch 1507.

However, in the conventional amplifier circuit as illustrated in Fig. 15, because the amplifiers which are matched according to the frequency are provided, four matching circuits 1503 to 1506 and the two amplifiers 1501 and 1502 are required, thereby increasing the area of a chip, and further, inducing an increase in cost.

SUMMARY OF THE INVENTION

Consequently, an object of the present invention is to provide an analog amplifier circuit that can be used at two frequency bands, wherein the area of a chip can be reduced, and further, the cost can be reduced.

To achieve the above-noted objects, the invention adopts the following basic technical constitution.

The aspect of the invention is an analog amplifier circuit having an amplifier, an input matching circuit thereof and an output matching circuit thereof, the input matching circuit and the output matching circuit comprising: a circuit portion which capacitively functions with respect to a first frequency while it inductively functions with respect to a second frequency, so as to perform impedance matching with respect to both of the first frequency and second frequency that is different from the first frequency.

A series resonance circuit comprising an inductor and a capacitor is used as the circuit which becomes capacitive with respect to the first frequency and becomes inductive with respect to the second frequency which is different from the first frequency in the matching circuit. Otherwise, a parallel resonance circuit comprising an inductor and a capacitor is used as the circuit that becomes capacitive with respect to the first frequency and becomes inductive with respect to the second frequency in the matching circuit.

Furthermore, another aspect of the invention is an analog amplifier circuit having an amplifier, an input matching circuit thereof and an output matching circuit thereof, the input matching circuit and the output matching circuit comprising: a phase rotating element for rotating a phase of an input signal to the amplifier or an output signal therefrom, to set the impedance of the phase rotating element in such a manner as to become inductive with respect to the first frequency and to become capacitive with respect to the second frequency which is different from the first frequency; and a circuit portion which capacitively functions with respect to the first frequency and inductively functions with respect to the second frequency, so as to perform impedance matching with respect to both of the first frequency and second frequency.

According to the invention, a series resonance circuit comprising an inductor and a capacitor is used as the circuit adjusted in such a manner as to become capacitive with respect to the first frequency while becoming inductive with respect to the second frequency; in the meantime, a parallel resonance circuit comprising an inductor and a capacitor is used as the circuit adjusted in such a manner as to become capacitive with respect to the first frequency while becoming inductive with respect to the second frequency. According to the invention, a transmission line is used as the phase rotating element.

Moreover, the impedance can be matched such that each of reflection coefficients from a signal source or a load is 0.3 or less with respect to the two frequencies, that is, a maximum gain of the amplifier can be achieved in the above mentioned matched state.

The impedance can be matched within the circle of a constant noise figure, which is lower, by 0.5dB than in the matched state in which minimum noise characteristics of the amplifier can be achieved with respect to the two frequencies.

Additionally, the impedance can be matched within a constant output circle, which is lower by 0.5dB than in the matched state in which a maximum saturated output of the amplifier can be achieved with respect to the two frequencies. Alternatively, the impedance is matched within a circle of a constant efficiency, which is lower, by 5% than in the matched state in which a maximum efficiency of the amplifier can be achieved with respect to the two frequencies. According to the invention, the amplifier is a bipolar transistor or a field effect transistor.

BRIEF DESCRIPTION OF THE DRAWINGS

Fig. 1 is a circuit diagram of the invention.
Fig. 2A is a diagram illustrating the locus of impedance conversion in the first embodiment of the invention.
Fig. 2B is a diagram illustrating the locus of impedance conversion in the second embodiment.
Fig. 2C is a diagram illustrating the locus of impedance conversion in the third embodiment.
Fig. 3 is a diagram illustrating impedance regions of a transistor in which a impedance can be converted to 50 $\Omega$ in each of first to sixth embodiments.
Fig. 4 is another circuit diagram of the invention.
Fig. 5A is a diagram illustrating the locus of impedance conversion in the fourth embodiment.
Fig. 5B is a diagram illustrating the locus of impedance conversion in the fifth embodiment.
Fig. 5C is a diagram illustrating the locus of impedance conversion in the sixth embodiment of the invention.
Fig. 6 is another circuit diagram of the invention.
Fig. 7A is a diagram illustrating the locus of impedance conversion in the seventh embodiment.
Fig. 7B is a diagram illustrating the locus of impedance conversion in the eighth embodiment.
Fig. 7C is a diagram illustrating the locus of impedance conversion in the ninth embodiment.
Fig. 8 is a diagram illustrating impedance regions of a transistor in which a impedance can be converted to 50 $\Omega$ in each of seventh to twelfth embodiments.
Fig. 9 is another circuit diagram of the invention.
Fig. 10A is a diagram illustrating the locus of impedance conversion in the tenth embodiment.
Fig. 10B is a diagram illustrating the locus of impedance conversion in the eleventh embodiment.
Fig. 10C is a diagram illustrating the locus of impedance conversion in the twelfth embodiment.
Fig. 11 is a circuit diagram illustrating the arrangement of a 13th embodiment.
Fig. 12 is a diagram illustrating the locus of impedance conversion in the 13th embodiment.
Fig. 13 is a circuit diagram illustrating the arrangement of a 14th embodiment.
Fig. 14 is a diagram illustrating the locus of impedance conversion in the 14th embodiment.
Fig. 15 is a circuit diagram illustrating the arrangement of a conventional amplifier circuit.

DETAILED DESCRIPTION OF THE PREFERRED EMBODIMENTS

A description will be given below of modes carrying out the invention. In configuring an amplifier circuit having a matching circuit, passive elements for use in the matching circuit mostly include a capacitor, an inductor and a transmission line without any electric power loss. Since the impedance of each of these elements varies according to frequency, it is difficult to match two frequency bands at the same time in the normal circuit arrangement.

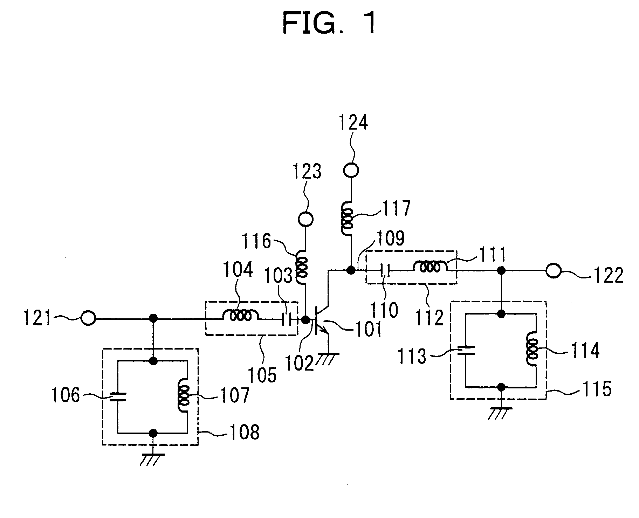

In view of this fact, two frequencies are matched at the same time with a circuit arrangement as illustrated in Fig. 1.

In Fig. 1, each of circuits 105, 108, 112 and 115 is either a series resonance circuit or a parallel resonance circuit.

For example, the circuit 105 is a series resonance circuit while the circuit 108 is a parallel resonance circuit. Explanation will be made on the case where an input impedance of a transistor:

$$Zs = 50 \times (0.3 - j0.2)$$
$$= 15 - j10$$

(wherein $j^2 = -1$)
is matched to 50 $\Omega$ with respect to two angular frequencies $\omega 1$ and $\omega 2$ ($\omega$ is $2\pi f$, wherein f represents a frequency, and here, $\omega$ is hereinafter referred to as "a frequency").

In the series resonance circuit 105 connected to a transistor 101, values of an inductor 104 and a capacitor 103, both of which are used in the resonance circuit 105, are suitably selected, and further, its resonance frequency is set between the first frequency $\omega 1$ and the second frequency $\omega 2$ ($\omega 1 < \omega 2$). Then, the impedance of the resonance circuit becomes inductive with respect to the first frequency $\omega 1$ while the impedance of the resonance circuit becomes capacitive with respect to the second frequency $\omega 2$ in the resonance circuit as a whole, thus causing that the resonance circuit looks like separate elements with respect to the two frequencies $\omega 1$ and $\omega 2$.

At this time, the input impedance of the device:

$$Zs = 50 \times (0.3 - j0.2)$$

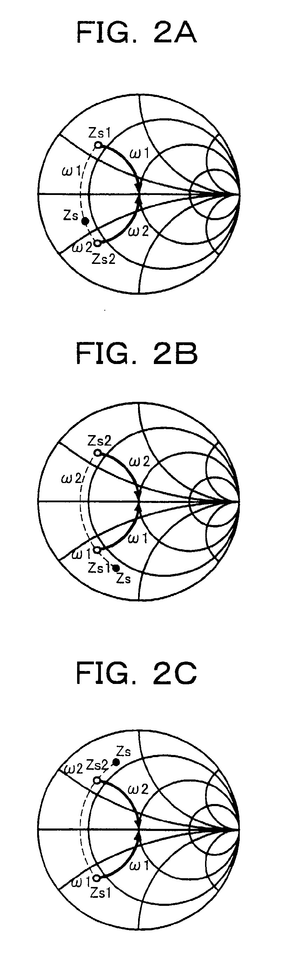

is moved clockwise along a constant resistance circle, in which R = 50 x 0.3 ($\Omega$), as illustrated in Fig. 2 (see an arrow $\omega 1$ in Fig. 2), since the impedance of the resonance circuit 105 is inductive at the first frequency $\omega 1$ by the circuit 105.

In contrast, the input impedance of the device is moved counterclockwise on the same constant resistance circle, as indicated by another arrow in Fig. 2, since the impedance of the resonance circuit is capacitive at the second frequency ω 2.

Here, in order to convert the impedance to 50 Ω by the use of the circuit 108, the destination of the conversion by the circuit 105 need be located along a constant conductance circle, in which G = 0.02 x 1 (S), passing through the center of the Smith chart.

The values of the capacitor 104 and the inductor 103, which meet the above-described condition, are determined as described below.

Since an intersection between the constant resistance circle, in which R = 50 x 0.3 (Ω), and the constant conductance circle, in which G = 0.02 x 1 (S), is located at 50 x (0.3 + j0.46), inductance L1 required by the resonance circuit 105 with respect to the first frequency ω1 becomes as follows:

$$J\omega 1 L1 = 50 \text{ x } (0.3 + j0.46) - 50 \text{ x } (0.3 - j0.2) = j33$$

In the same manner, since another intersection between the above-described two circles is located at 50 x (0.3 - j0.46), a capacitance required by the resonance circuit 105 with respect to the second frequency ω2 becomes as follows:

$$1/J\omega 2 C1 = 50 \text{ x } (0.3 - j0.46) - 50 \text{ x } (0.3 - j0.2) = -j13$$

As a result, since the impedance of the entire resonance circuit is j (ωL - 1/ωC), the inductance L1 of the resonance circuit 105 with respect to the first frequency ω1 and the capacitance C1 of the resonance circuit 105 with respect to the second frequency ω2 can be obtained by getting solutions to the following two equations:

ω1L - 1/ω1C = ω1L1 = 33 with respect to the first frequency ω1; and

ω2L - 1/ω2C = 1/ω2C1 = 13 with respect to the second frequency ω2, wherein reference character L designates the inductance value of the inductor 104 for use in the circuit 105 and reference sign C denotes the capacitance value of the capacitor 103.

Since unknown values in the above-described two equations are the inductance L and the capacitance C in this case, each of the equations has a unique solution. Consequently, the use of the series resonance circuit 105 enables the impedance of the device to be converted to the value along the constant conductance circle at the two frequencies.

Thereafter, the two points along the constant conductance circle, in which G = 0.02 (S), converted by the series resonance circuit 105 are converted into 50 Ω by the parallel resonance circuit 108.

In the case of the parallel resonance circuit, values of the inductor and the capacitor, both of which are used in the resonance circuit, are suitably selected, and further, its resonance frequency is set between the first frequency ω1 and the second frequency ω2 (ω1 < ω2). Then, the impedance of the resonance circuit becomes capacitive with respect to the first frequency ω1 while the impedance of the resonance circuit becomes inductive with respect to the second frequency ω2 in the resonance circuit.

In order to convert the points on the circle, in which G = 0.02 (S) , that is, 50 x (0.3 + j0.46) and 50 x (0.3 - j0.46) {which are 0.02 x (1 - j1.5) and 0.02 x (1 + j1.5) based on admittance, respectively} into 50 Ω, C2 and L2 meeting equations below are required:

jω1C2 = 0.02 - 0.02 x (1 - j1.5) = j0.03 with respect to the first frequency ω1; and

1/jω2L2 = 0.02 - 0.02 x (1 + j1.5) = -j0.03 with respect to the second frequency ω2.

Therefore, in order to establish the inductance value L2 and capacitance value C2 of the parallel resonance circuit 108, since the entire admittance is ωC - 1/ωL, the inductance L2 of the parallel resonance circuit 108 and the capacitance C2 of the resonance circuit can be obtained by getting solutions to the following two equations:

ω1C - 1/ω1L = 0.03; and

ω2C - 1/ω2L = -0.03, wherein reference character L designates the inductance value of an inductor 107 for use in the circuit 108 and reference character C the capacitance value of a capacitor 106.

Since unknown values in the above-described two equations are L and C in this case, each of the equations has a unique solution. Consequently, the use of the parallel resonance circuit 108 enables the impedance of the device to be converted to 50 Ω at the two frequencies.

Although the explanation has been made on the circuit arrangement and its function, in which the impedance:

$$R = 50 \text{ x } (0.3 - j0.2) = 15 - j10$$

is matched to 50 Ω at the two frequencies, the circuit 105 may be a parallel resonance circuit while the circuit 108 may be a series resonance circuit according to the impedance of the device.

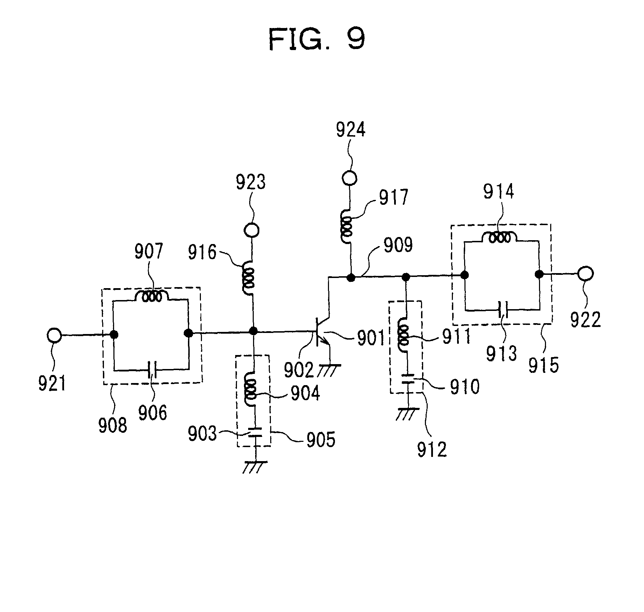

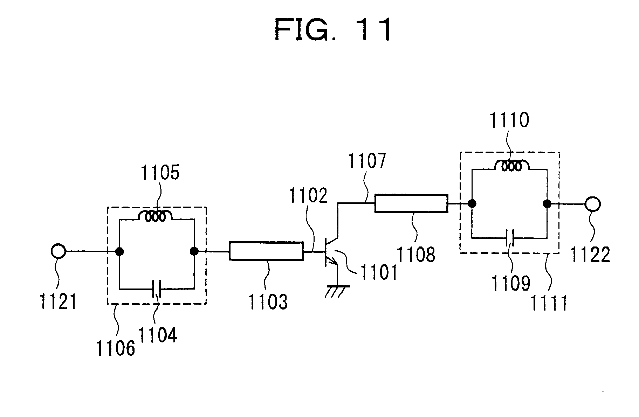

Alternatively, as illustrated in Fig. 9 or 11, a parallel circuit may be first connected to the input terminal, and then, a series circuit may be connected to the parallel circuit.

With any arrangement, the element parameters are determined based on the same concept as that of the above-described specific mode, thus producing the same functions and effects as those in the above-described specific mode.

In another mode according to the invention, the impedance of a device can be converted into a desired impedance by the use of a resonance circuit after performing a phase shift of the impedance on a transmission line. Referring to Fig. 11, the phase is rotated on a transmission line 1103 in such a manner that the impedance of an amplifier becomes inductive at a first frequency $\omega 1$ while it becomes capacitive at a second frequency $\omega 2$, and then, the impedance is converted into a value around the center of the Smith chart by the resonance circuit.

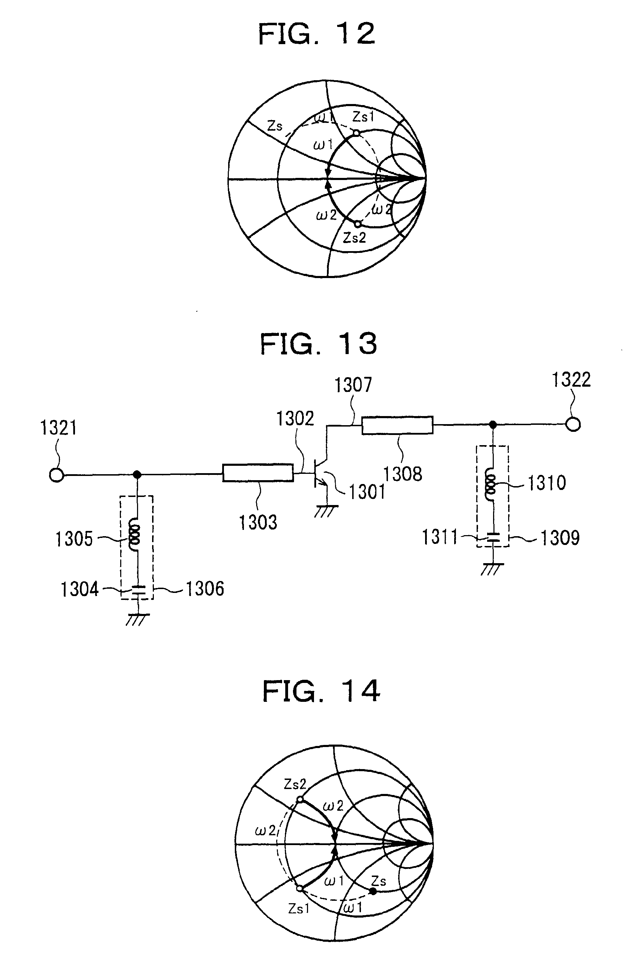

For example, when input impedance of the device R = 50 x (0.3 + j0.46) ($\Omega$) is matched to 50 $\Omega$, the length of the transmission line 1103 for rotating the phase is designed such that the phase is rotated by 37° at the first frequency $\omega 1$ while by 90° at the second frequency $\omega 2$, so that the impedance after the rotation of the phase becomes 50 + j76 ($\Omega$) which is inductive at the first frequency $\omega 1$ while 50 - j76 ($\Omega$) which is capacitive at the second frequency $\omega 2$, as illustrated in Fig. 12.

Furthermore, since in this case, the input impedance is on a constant resistance circle, in which R = 50 $\Omega$, a parallel resonance circuit is connected in series, in which the impedance is -j76 $\Omega$ at $\omega 1$ while j76 $\Omega$ at $\omega 2$, so that the impedance can be converted to 50 $\Omega$ at the center of the Smith chart at both of the two frequencies, for the same reason as described above.

In this manner, the use of the transmission line and the resonance circuit enables the impedance to be converted at both of the two frequencies.

Moreover, the above-described technique can be applied to the case where an active element constituting the amplifier is either a bipolar transistor or a field effect transistor in the same manner, thus providing the matching circuit for converting the impedance into an optimum impedance at either of the two frequencies.

Next, examples according to the invention will be described in reference to the accompanying drawings.

(First embodiment)

Fig. 1 is a circuit diagram illustrating the arrangement of the first embodiment of the invention.

There are provided a series resonance circuit 105 including a capacitor 103 and an inductor 104, connected in series between an input (a base) 102 of a transistor 101 having a grounded emitter and an input terminal 121; a parallel resonance circuit 108 including a capacitor 106 and an inductor 107, connected in parallel between the input terminal 121 and a ground; another series resonance circuit 112 including a capacitor 110 and an inductor 111, connected in series between an output (a collector) 109 of the transistor 101 and an output terminal 122; and another parallel resonance circuit 115 including a capacitor 113 and an inductor 114, connected in parallel between the output terminal 122 and the ground. Inductors 116 and 117 are bias choke coils, which are connected to the input and output of the transistor 101 at respective ends thereof while connected to bias power at the respective other ends 123 and 124 thereof.

In this example according to the invention, the series resonance circuits 105 and 112 provided in series inductively function with respect to a first frequency $\omega 1$ while they capacitively function with respect to a second frequency $\omega 2$ ($\omega 1 < \omega 2$) by the above-described technique.

At this time, an input impedance Zs is moved to points Zs1 and Zs2 with respect to $\omega 1$ and $\omega 2$, respectively, on the Smith chart, as indicated by a broken line in Fig. 2A.

In contrast, the parallel resonance circuits 108 and 115 capacitively function with respect to the frequency $\omega 1$ while they inductively function with respect to the frequency $\omega 2$. At this time, Zs1 and Zs2 are moved as indicated by a solid line in Fig. 2A. As a result, the impedance can be matched at one and the same point (to 50 $\Omega$ in this example) with respect to both of the two frequencies.

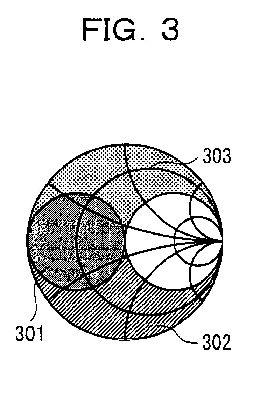

Theoretically, in the case where the input/output impedance of the transistor 101 falls within a region 301 in Fig. 3, the impedance can be matched to 50 $\Omega$ with respect to both of the two frequencies with the above-described arrangement.

(Second embodiment)

Subsequently, a description will be given of a second embodiment of the present invention. In the second embodiment of the present invention, series resonance circuits 105 and 112 inductively function with respect to both of a first frequency $\omega 1$ and a second frequency $\omega 2$ in the arrangement illustrated in Fig. 1. In this case, if a impedance Zs of a transistor falls within a region 302 in Fig. 3, the impedance can be matched to 50 $\Omega$ with respect to both of the two frequencies. In other words, in the case where the input impedance of the device falls within the region 302, the parallel resonance circuits 108 and 115 convert the impedance of the device into 50 $\Omega$ from a capacitive part (i.e., an imaginary part is negative) on a constant conductance circle, in which G = 0.02 (S), with respect to the first frequency $\omega 1$ while into 50 $\Omega$ from an inductive part (i.e., an imaginary part is positive) with respect to the second frequency $\omega 2$. Fig. 2B is a diagram illustrating the locus of impedance conversion in the second embodiment.

(Third embodiment)

Furthermore, a description will be given of a third embodiment according to the invention.

Series resonance circuits 105 and 112 capacitively function with respect to both of a first frequency $\omega 1$ and a second frequency $\omega 2$ in the arrangement illustrated in Fig. 1. In this case, if an input impedance Zs of a transistor falls within a region 303 in Fig. 3, the impedance can be matched to 50 $\Omega$ with respect to both of the two frequencies. In other words, in the case where the impedance of the device falls within the region 303, the parallel resonance circuits 108 and 115 convert the impedance of the device into 50 Ω from an inductive part (i.e., an imaginary part is positive) on a constant conductance circle, in which G = 0.02 (S), with respect to the second frequency ω2 while into 50 Ω from a capacitive part (i.e., an imaginary part is negative) with respect to the first frequency (1. Fig.2C is a diagram illustrating the locus of impedance conversion in the third embodiment.

(Fourth embodiment)

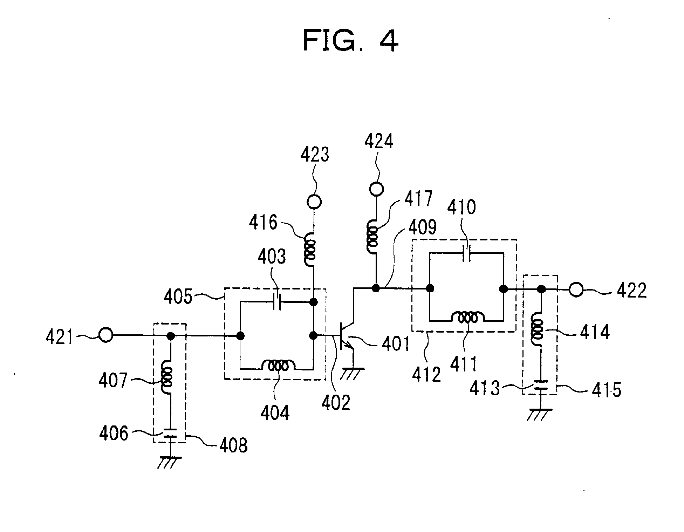

Fig. 4 is a circuit diagram illustrating the arrangement of another example according to the invention.

There are provided a parallel resonance circuit 405 including a capacitor 403 and an inductor 404 connected in parallel between an input (a base) 402 of a transistor 401 having a grounded emitter and an input terminal 421; a series resonance circuit 408 including a capacitor 406 and an inductor 407 connected in series between the input terminal 421 and a ground; another parallel resonance circuit 412 including a capacitor 410 and an inductor 411 connected in series between an output (a collector) 409 of the transistor 401 and an output terminal 422; and another series resonance circuit 415 including a capacitor 413 and an inductor 414 connected in series between the output terminal 422 and the ground. Inductors 416 and 417 are bias choke coils, and terminals 423 and 424 are connected to bias power sources.

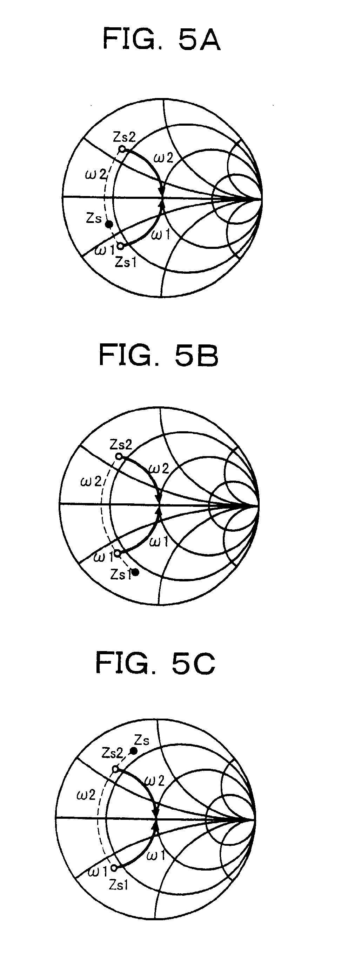

In the fourth embodiment of the invention in Fig. 4, the parallel resonance circuits 405 and 412 provided in series capacitively function with respect to a first frequency ω1 while they inductively function with respect to a second frequency ω2 (ω1 < ω2) by the above-described technique. At this time, an input impedance Zs is moved to points Zs1 and Zs2 with respect to ω1 and ω2, respectively, on the Smith chart, as indicated by a broken line in Fig. 5A.

In contrast, the series resonance circuits 108 and 115 inductively function with respect to the frequency ω1 while they capacitively function with respect to the frequency ω 2. At this time, Zs1 and Zs2 are moved as indicated by a solid line in Fig. 5A.

With this arrangement, the impedance can be matched at one and the same point (to 50 Ω in this example) with respect to both of the two frequencies. Theoretically, in the case where the input/output impedance of the transistor falls within a region 301 in Fig. 3, the impedance can be matched to 50 Ω with respect to both of the two frequencies with the above-described arrangement.

(Fifth embodiment)

Subsequently, a description will be given of a fifth embodiment according to the invention.

Parallel resonance circuits 405 and 412 inductively function with respect to both of a first frequency ω1 and a second frequency ω2 in the arrangement illustrated in Fig. 4. In this case, if an input impedance Zs of a transistor 401 falls within a region 302 in Fig. 3, the impedance can be matched to 50 Ω with respect to both of the two frequencies. That is to say, in the case where the impedance of the device falls within the region 302, the series resonance circuits 408 and 415 convert the impedance of the device into 50 Ω from a capacitive part (i.e., an imaginary part is negative) on a constant conductance circle, in which G = 0.02 (S), with respect to the first frequency ω1 while into 50 Ω from an inductive part (i.e., an imaginary part is positive) with respect to the second frequency ω2. Fig.5B is a diagram illustrating the locus of impedance conversion in the fifth embodiment.

(Sixth embodiment)

Next, description will be given of a sixth embodiment.

Parallel resonance circuits 405 and 412 capacitively function with respect to both of a first frequency ω1 and a second frequency ω2 in the arrangement illustrated in Fig. 4. In this case, if an input impedance Zs of a transistor falls within a region 303 in Fig. 3, the impedance can be matched to 50 Ω with respect to both of the two frequencies. In other words, in the case where the impedance of the device falls within the region 303, the series resonance circuits 408 and 415 convert the impedance of the device into 50 Ω from an inductive part (i.e., an imaginary part is positive) on a constant conductance circle, in which G = 0.02 (S), with respect to the second frequency ω2 while into 50 Ω from a capacitive part (i.e., an imaginary part is negative) with respect to the first frequency ω1. Fig.5C is a diagram illustrating the locus of impedance conversion in the sixth embodiment.

(Seventh embodiment)

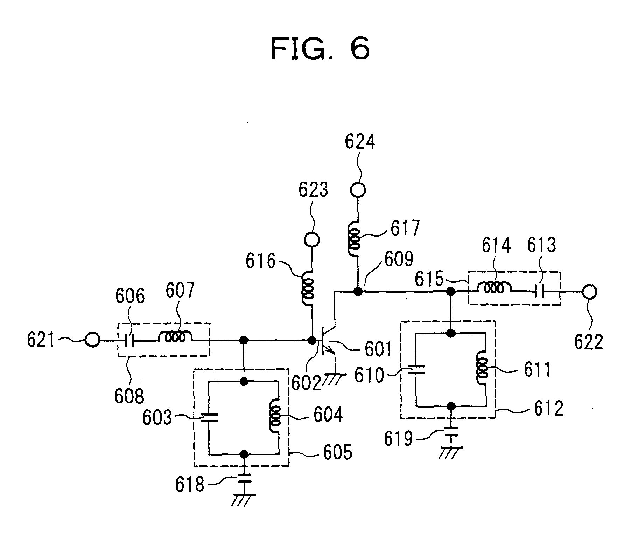

Fig. 6 is a circuit diagram illustrating the arrangement of a further example according to the invention.

There are provided a parallel resonance circuit 605 including a capacitor 603 and an inductor 604 connected in parallel between an input (a base) 602 of a transistor 601 having a grounded emitter and a ground; a series resonance circuit 608 including a capacitor 606 and an inductor 607 connected in series between the input 602 of the transistor 601 and an input terminal 621; another parallel resonance circuit 612 including a capacitor 610 and an inductor 611 connected in parallel between an output (a collector) 609 of the transistor 601 and the ground; and another series resonance circuit 615 including a capacitor 613 and an inductor 614 connected in series between the output 609 of the transistor 601 and an output terminal 622. Inductors 616 and 617 are bias choke coils. Here, reference numerals 618 and 619 designate DC cutting capacitors.

Subsequently, description will be made of a seventh embodiment:

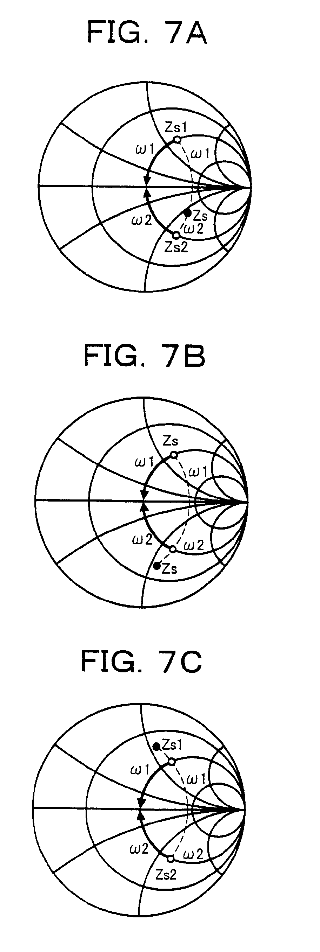

The parallel resonance circuits 605 and 612 inductively function with respect to a first frequency $\omega 1$ while they capacitively function with respect to a second frequency $\omega 2$ ($\omega 1 < \omega 2$) by the above-described technique in the arrangement illustrated in Fig. 6. At this time, an input impedance Zs of the transistor is moved to points Zs1 and Zs2 on the Smith chart with respect to $\omega 1$ and $\omega 2$, as indicated by a broken line in Fig. 7A.

In contrast, the series resonance circuits 608 and 615 capacitively function with respect to the frequency $\omega 1$ while they inductively function with respect to the frequency $\omega 2$. At this time, Zs1 and Zs2 are moved as indicated by a solid line in Fig. 7A. As a result, the impedance can be matched at one and the same point (to 50 $\Omega$ in this example) with respect to both of the two frequencies.

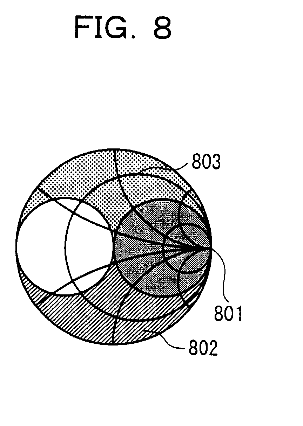

Theoretically, in the case where the input/output impedance of the transistor falls within a region 801 in Fig. 8, the impedance can be matched to 50 $\Omega$ with respect to both of the two frequencies with the above-described arrangement.

(Eighth embodiment)

Subsequently, description will be made of an eighth embodiment.

Parallel resonance circuits 605 and 612 inductively function with respect to both of a first frequency $\omega 1$ and a second frequency $\omega 2$ in the arrangement illustrated in Fig. 6. In this case, if an input impedance Zs of a transistor falls within a region 802 in Fig. 8, the impedance can be matched to 50 $\Omega$ with respect to both of the two frequencies. That is to say, in the case where the impedance of the device falls within the region 802, the series resonance circuits 608 and 615 convert the impedance of the device into 50 $\Omega$ from an inductive part (i.e., an imaginary part is positive) on a constant resistance circle, in which R = 50 $\Omega$, with respect to $\omega 1$ while into 50 $\Omega$ from a capacitive part (i.e., an imaginary part is negative) with respect to $\omega 2$. Fig.7B is a diagram illustrating the locus of impedance conversion in the eighth embodiment .

(Ninth embodiment)

Next, a description will be given of a ninth embodiment.

Parallel resonance circuits 605 and 612 inductively function with respect to both of a first frequency $\omega 1$ and a second frequency $\omega 2$ in the arrangement illustrated in Fig. 6. In this case, if an input impedance Zs of a transistor falls within a region 803 in Fig. 8, the impedance can be matched to 50 $\Omega$ with respect to both of the two frequencies. That is to say, in the case where the impedance of the device falls within the region 803, the series resonance circuits 608 and 615 convert the impedance of the device into 50 $\Omega$ from an inductive part (i.e., an imaginary part is positive) on a constant resistance circle, in which R = 50 $\Omega$ , with respect to $\omega 1$ while into 50 $\Omega$ from a capacitive part (i.e., an imaginary part is negative) with respect to $\omega 2$. Fig.7C is a diagram illustrating the locus of impedance conversion in the ninth embodiment.

(Tenth embodiment)

Fig. 9 is a circuit diagram illustrating the arrangement of a still further example.

In this example, there are provided a series resonance circuit 905 including a capacitor 903 and an inductor 904 connected in series between an input (a base) 902 of a transistor 901 having a grounded emitter and a ground; a parallel resonance circuit 908 including a capacitor 906 and an inductor 907 connected in parallel between the input 902 of the transistor 901 and an input terminal 921; another series resonance circuit 912 including a capacitor 910 and an inductor 911 connected in series between an output (a collector) 909 of the transistor 901 and the ground; and another parallel resonance circuit 915 including a capacitor 913 and an inductor 914 connected in parallel between the output 909 of the transistor 901 and an output terminal 922. Inductors 916 and 917 are bias choke coils, to which bias voltages are supplied from terminals 923 and 924, respectively.

Subsequently, a description will be given of a tenth embodiment.

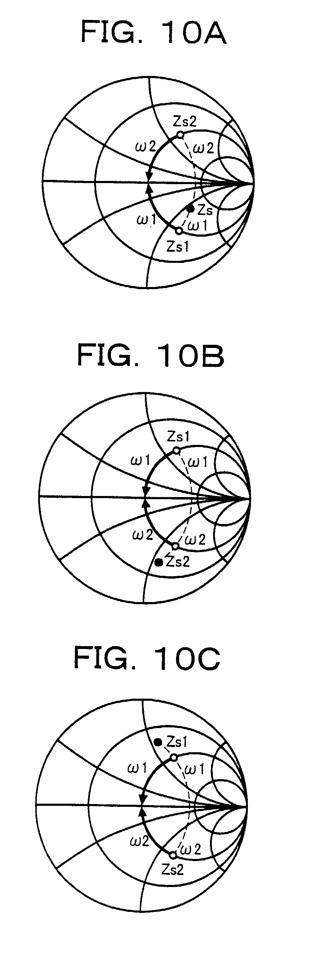

The series resonance circuits 905 and 912 inductively function with respect to a first frequency $\omega 1$ while they capacitively function with respect to a second frequency $\omega 2$ ($\omega 1 < \omega 2$) by the above-described technique in the arrangement illustrated in Fig. 9. At this time, a transistor terminal impedance Zs is moved to points Zs1 and Zs2 on the Smith chart with respect to $\omega 1$ and $\omega 2$, as indicated by a broken line in Fig. 10A.

In contrast, the parallel resonance circuits 908 and 915 connected in series capacitively function with respect to the frequency $\omega 1$ while they inductively function with respect to the frequency $\omega 2$. At this time, Zs1 and Zs2 are moved as indicated by a solid line in Fig. 10A. As a result, the impedance can be matched at one and the same point (to 50 $\Omega$ in this example) with respect to both of the two frequencies.

Theoretically, in the case where the input/output impedance of the transistor falls within a region 801 in Fig. 8, the impedance can be matched to 50 $\Omega$ with respect to both of the two frequencies.

(Eleventh embodiment)

Subsequently, a description will be given of an eleventh embodiment.

Series resonance circuits 905 and 912 inductively function with respect to both of a first frequency ω1 and a second frequency ω2 in the arrangement illustrated in Fig. 9. In this case, if an input impedance Zs of a transistor 901 falls within a region 802 in Fig. 8, the impedance can be matched to 50 Ω with respect to both of the two frequencies. That is to say, in the case where the impedance of the device (i.e., the transistor 901) falls within the region 802, the parallel resonance circuits 908 and 915 convert the impedance of the device into 50 Ω from an inductive part (i.e., an imaginary part is positive) on a constant resistance circle, in which R = 50 Ω, with respect to ω1 while into 50 Ω from a capacitive part (i.e., an imaginary part is negative) with respect to ω2. Fig. 10B is a diagram illustrating the locus of impedance conversion in the eleventh embodiment.

(Twelfth embodiment)

Next, a description will be given of a twelfth embodiment.

Series resonance circuits 905 and 912 capacitively function with respect to both of a first frequency ω1 and a second frequency ω2 in the arrangement illustrated in Fig. 9. In this case, if an input impedance of a transistor falls within a region 303 in Fig. 3, the impedance can be matched to 50 Ω with respect to both of the two frequencies. In other words, in the case where the impedance of the device falls within the region 303, the parallel resonance circuits 905 and 912 convert the impedance of the device into 50 Ω from an inductive part (i.e., an imaginary part is positive) on a constant resistance circle, in which R = 50 Ω, with respect to ω1 while into 50 Ω from a capacitive part (i.e., an imaginary part is negative) with respect to ω2. Fig. 10C is a diagram illustrating the locus of impedance conversion.

Although the matching circuits respectively disposed at the input and the output are of the same type in the above described first to twelfth embodiments, matching circuits of different types in combination can produce the same effects.

(13th embodiment)

Referring to Fig. 11, in this embodiment, there are provided a phase rotating element 1103, and a parallel resonance circuit 1106 including a capacitor 1104 and an inductor 1105 connected in parallel, the element 1103 and the circuit 1106 being connected in series between an input (a base) 1102 of a transistor 1101 having a grounded emitter and an input terminal 1121; and a phase rotating element 1108, and another parallel resonance circuit 1111 including a capacitor 1109 and an inductor 1110 connected in parallel, the element 1108 and the circuit 1111 being connected in series between an output (a collector) 1107 of the transistor 1101 and an output terminal 1122. The phase of the input impedance and output impedance of the transistor 1101 is rotated so as to become inductive with respect to a first frequency ω1 and capacitive with respect to a second frequency ω2, and further, the parallel resonance circuit which becomes capacitive with respect to the first frequency ω1 while becomes inductive with respect to the second frequency ω2 is connected in series, thereby matching the two frequencies at the same time. With respect to the frequencies ω1 and ω2, a transistor terminal impedance Zs is moved to an inductive impedance Zs1 at the first frequency ω1 while to a capacitive impedance Zs2 at the second frequency ω2 on the Smith chart by the phase rotating elements 1103 and 1108, as indicated by a broken line in Fig. 12 (in this case, ω1 < ω2).

Moreover, when the parallel resonance circuits 1106 and 1111 capacitively function with respect to the first frequency ω1 while they inductively function with respect to the second frequency ω2, Zs moves as indicated by a solid line in Fig. 12. As a result, the impedance can be matched (to 50 Ω in this example) with respect to the two frequencies. Additionally, the impedance of the device can be allowed to approach an optimum matching point.

(14th embodiment)

Referring to Fig. 13, in this embodiment, there are provided a phase rotating element 1303 connected between an input (a base) 1302 of a transistor 1301 and an input terminal 1321; a series resonance circuit 1306 including a capacitor 1304 and an inductor 1305, connected in series between a connecting point of the input terminal 1321 to the phase rotating element 1303 and a ground; a phase rotating element 1308 connected between an output (a collector) 1307 of the transistor 1301 and an output terminal 1322; and another series resonance circuit 1311 including a capacitor 1309 and an inductor 1310, connected between a connecting point of the phase rotating element 1308 to the output terminal 1322 and the ground. With this circuit arrangement, the phase of the input impedance and output impedance of the transistor 1301 are rotated so as to become capacitive with respect to a first frequency ω1 and become inductive with respect to a second frequency ω2, and further, the circuit which becomes inductive with respect to the first frequency ω1 while becomes capacitive with respect to the second frequency ω2 is connected in parallel, thereby matching the two frequencies at the same time.

With respect to the frequencies ω1 and ω2, a transistor terminal impedance Zs is moved to a capacitive impedance Zs1 at the first frequency ω1 while to an inductive impedance Zs2 at the second frequency ω2 on the Smith chart by the phase rotating elements 1303 and 1308, as indicated by a broken line in Fig. 14 (in this case, ω1 < ω2).

Moreover, when the series resonance circuits 1306 and 1311 inductively function with respect to the first frequency ω1 while they capacitively function with respect to the second frequency ω2, Zs moves as indicated by a solid line in Fig. 14. As a result, the impedance can be matched (to 50 Ω in this example) with respect to the two frequencies. In this way, the impedance of the device can be allowed to approach an optimum matching point.

(15th embodiment)

In a 15th embodiment , when each of reflection coefficients from a signal source or a load is 0.3 or less with respect to the two frequencies, a maximum gain of the amplifier can be achieved in the matched state in each of the above-described first to 14th examples. In the case in which the reflection coefficient from the load or the signal source is 0.3 or less, i.e., -10 dB or less at the two frequencies, the amplifier circuit can achieve the maximum gain due to a reduced electric power loss.

(16th embodiment)

In a 16th embodiment, the impedance can be within the circle of a constant noise figure which is higher by 0.5 dB than in the matched state in which minimum noise characteristics of the amplifier can be achieved with respect to the two frequencies in each of the above-described first to 14th embodiments. In this case, degradation of the noise characteristics from the optimum value can be suppressed to 12% or less, thereby achieving the excellent amplifier having lower noise.

(17th embodiment)

In a 17th embodiment, the impedance can be matched within a constant output circle which is lower by 0.5 dB than in the matched state in which a maximum saturated output of the amplifier can be achieved with respect to the two frequencies in each of the above-described first to 14th embodiments. In this case, degradation of the saturated output can be suppressed to 12% or less in a transmission power amplifier having a high saturated output.

(18th embodiment)

In an 18th embodiment, the impedance is within a circle of a constant efficiency which is lower by 5% than in the matched state in which a maximum efficiency of the amplifier can be achieved with respect to the two frequencies in each of the above-described first to 14th embodiments.

Since power consumption of the power amplifier for the mobile terminal in the mobile telephone or the like occupies about 60% of the total power consumption, the invention is effective because it can achieve the amplifier in which the degradation of efficiency can be suppressed to the minimum.

Although in each of the above-described embodiments, the bipolar transistor has been used as the amplifier device, a field effect transistor may be used instead. The amplifier circuit of a high gain can be achieved in the case of the use of the bipolar transistor; an amplifier circuit of a low cost can be achieved in a silicon-based device in the case of the use of the field effect transistor; and an amplifier circuit of a high efficiency can be achieved in a compound-based device in the case of the use of the field effect transistor. The optimum device can be appropriately selected according to the specifications required for the system.

As described above, the matching circuit according to the invention is configured by the use of at least one of a circuit which becomes capacitive with respect to a first frequency while becomes inductive with respect to a second frequency, so as to match with respect to both of the first frequency and the second frequency at the same time, thereby producing the effect that the arrangement with only one amplifier can cover both of the two bands. In comparison with the conventional circuit arrangement, the elements can be reduced in size and number, thus reducing the area occupied by the amplifier circuit and reducing the manufacturing cost.

**Claims**

1. Analog amplifier circuit having an amplifier element, an input matching circuit thereof and an output matching circuit thereof, said input matching circuit and said output matching circuit comprising:

   a circuit portion which capacitively functions with respect to a first frequency while inductively functioning with respect to a second frequency which is different from said first frequency, so as to perform impedance matching with respect to both of said first frequency and second frequency.

2. Analog amplifier circuit having an amplifier element, an input matching circuit thereof and an output matching circuit thereof, said input matching circuit and said output matching circuit comprising:

   a phase rotating element for rotating a phase of an input signal to said amplifier element and that of an output signal therefrom, so as to set an impedance of said phase rotating element in such a manner as to become inductive with respect to said first frequency while to become capacitive with respect to said second frequency which is different from said first frequency;

and

    a circuit portion which capacitively functions with respect to said first frequency while inductively functioning with respect to said second frequency, so as to perform impedance matching with respect to both of said first frequency and second frequency.

3.   Circuit according to claim 1 or 2, wherein said circuit portion comprising a series resonance circuit has an inductor and a capacitor.

4.   Circuit according to claim 1 or 2, wherein said circuit portion comprising a parallel resonance circuit has an inductor and a capacitor.

5.   Circuit according to claim 1 or 2, wherein said phase rotating element comprises a transmission line.

6.   Circuit according to any one of claims 1 to 5, wherein each of reflection coefficients of a signal source side and a load side is 0.3 or less with respect to said first frequency and said second frequency, in a matched state.

7.   Circuit according to any one of claims 1 to 6, wherein the input impedance and output impedance of said analog amplifier circuit in a matched state fall within a circle of a constant noise figure which is higher by 0.5 dB on a Smith chart than a state in which minimum noise characteristics of said amplifier element can be achieved with respect to said first frequency and said second frequency.

8.   Circuit according to any one of claims 1 to 6, wherein the input impedance and output impedance of said analog amplifier circuit in a matched state falls within a circle of a constant output which is lower by 0.5 dB on a Smith chart than a state in which a maximum saturated output of said amplifier element can be achieved with respect to said first frequency and said second frequency.

9.   Circuit according to any one of claims 1 to 6, wherein the input impedance and output impedance of said analog amplifier circuit in a matched state fall within a circle of a constant efficiency which is lower by 5% on a Smith chart than a state in which a maximum efficiency of said amplifier element can be achieved with respect to said first frequency and said second frequency.

10.  Circuit according to any one of claims 1 to 9, wherein said amplifier element comprises a bipolar transistor.

11.  Circuit according to any one of claims 1 to 9,

wherein said amplifier element comprises a field effect transistor.

12.  Analog amplifier circuit having a transistor serving as an amplifier, an input matching circuit thereof and an output matching circuit thereof, an input terminal of said analog amplifier circuit and an output terminal of said analog amplifier circuit,
    said input matching circuit comprising:

    a first series resonance circuit having a first capacitor and a first inductor, connected in series between an input terminal of said transistor and said input terminal of said analog amplifier circuit; and
    a first parallel resonance circuit having a second capacitor and a second inductor, connected in parallel between said input terminal of said analog amplifier circuit and the ground;

    said output matching circuit comprising:

    a second series resonance circuit having a third capacitor and a third inductor, connected in series between an output terminal of said transistor and said output terminal of said analog amplifier circuit; and
    a second parallel resonance circuit having a fourth capacitor and a fourth inductor, connected in parallel between said output terminal of said analog amplifier circuit and the ground;

    wherein said first and second series resonance circuits inductively function with respect to a first frequency while said first and second series resonance circuits capacitively function with respect to a second frequency which is different from said first frequency, so as to perform impedance matching with respect to said first frequency and said second frequency.

13.  Circuit according to claim 12, wherein said first and second parallel resonance circuits capacitively function with respect to said first frequency while said first and second parallel resonance circuits inductively function with respect to said second frequency.

14.  Analog amplifier circuit having a transistor serving as an amplifier, an input matching circuit thereof and an output matching circuit thereof, an input terminal of said analog amplifier circuit and an output terminal of said analog amplifier circuit,
    said input matching circuit comprising:

    a first series resonance circuit having a first capacitor and a first inductor, connected in series between an input terminal of said transistor and said input terminal of said analog amplifier circuit; and
a first parallel resonance circuit having a second capacitor and a second inductor, connected in parallel between said input terminal of said analog amplifier circuit andthe ground;

said output matching circuit comprising:

a second series resonance circuit having a third capacitor and a third inductor, connected in series between an output terminal of said transistor and said output terminal of said analog amplifier circuit; and
a second parallel resonance circuit having a fourth capacitor and a fourth inductor, connected in parallel between said output terminal of said analog amplifier circuit and the ground;

wherein said first and second series resonance circuits inductively function with respect to both of a first frequency and a second frequency which is different from said first frequency, and said first and second parallel resonance circuits inductively function with respect to said first frequency while said first and second parallel resonance circuits capacitively function with respect to said second frequency.

15. Analog amplifier circuit having a transistor serving as an amplifier, an input matching circuit thereof and an output matching circuit thereof, an input terminal of said analog amplifier circuit and an output terminal of said analog amplifier circuit,
said input matching circuit comprising:

a first series resonance circuit having a first capacitor and a first inductor, connected in series between an input terminal of said transistor and said input terminal of said analog amplifier circuit; and
a first parallel resonance circuit having a second capacitor and a second inductor, connected in parallel between said input terminal of said analog amplifier circuit and the ground;

said output matching circuit comprising:

a second series resonance circuit having a third capacitor and a third inductor, connected in series between an output terminal of said transistor and said output terminal of said analog amplifier circuit; and
a second parallel resonance circuit having a fourth capacitor and a fourth inductor, connected in parallel between said output terminal of said analog amplifier circuit and the ground;

wherein said first and second series resonance circuits capacitively function with respect to both of a first frequency and a second frequency which is different from said first frequency, and said first and second parallel resonance circuits inductively function with respect to said first frequency while said first and second parallel resonance circuits capacitively function with respect to said second frequency.

16. Analog amplifier circuit having a transistor serving as an amplifier, an input matching circuit thereof and an output matching circuit thereof, an input terminal of said analog amplifier circuit and an output terminal of said analog amplifier circuit,
said input matching circuit comprising:

a first parallel resonance circuit having a first capacitor and a first inductor, connected in parallel between an input terminal of said transistor and said input terminal of said analog amplifier circuit; and
a first series resonance circuit having a second capacitor and a second inductor, connected in series between said input terminal of said analog amplifier circuit and the ground;

said output matching circuit comprising:

a second parallel resonance circuit having a third capacitor and a third inductor, connected in parallel between an output terminal of said transistor and said output terminal of said analog amplifier circuit; and
a second series resonance circuit having a fourth capacitor and a fourth inductor, connected in series between said output terminal of said analog amplifier circuit and the ground;

wherein said first and second parallel resonance circuits capacitively function with respect to a first frequency while said first and second parallel resonance circuits inductively function with respect to a second frequency which is different from said first frequency, so as to perform impedance matching with respect to said first frequency and said second frequency.

17. Circuit according to claim 16,
wherein said first and second series resonance circuits inductively function with respect to said first frequency while said first and second series resonance circuits capacitively function with respect to said second frequency.

18. Analog amplifier circuit having a transistor serving as an amplifier, an input matching circuit thereof and an output matching circuit thereof, an input terminal of said analog amplifier circuit and an output terminal of said analog amplifier circuit,

said input matching circuit comprising:

a first parallel resonance circuit having a first capacitor and a first inductor, connected in parallel between an input terminal of said transistor and said input terminal of said analog amplifier circuit; and

a first series resonance circuit having a second capacitor and a second inductor, connected in series between said input terminal of said analog amplifier circuit andthe ground;

said output matching circuit comprising:

a second parallel resonance circuit having a third capacitor and a third inductor, connected in parallel between an output terminal of said transistor and said output terminal of said analog amplifier circuit; and

a second series resonance circuit having a fourth capacitor and a fourth inductor, connected in series between said output terminal of said analog amplifier circuit and the ground;

wherein said first and second parallel resonance circuits inductively function with respect to both of a first frequency and a second frequency which is different from said first frequency, and said first and second series resonance circuits inductively function with respect to said first frequency while said first and second series resonance circuits capacitively function with respect to said second frequency.

19. Analog amplifier circuit having a transistor serving as an amplifier, an input matching circuit thereof and an output matching circuit thereof, an input terminal of said analog amplifier circuit and an output terminal of said analog amplifier circuit,

said input matching circuit comprising:

a first parallel resonance circuit having a first capacitor and a first inductor, connected in parallel between an input terminal of said transistor and said input terminal of said analog amplifier circuit; and

a first series resonance circuit having a second capacitor and a second inductor, connected in series between said input terminal of said analog amplifier circuit and the ground;

said output matching circuit comprising:

a second parallel resonance circuit having a third capacitor and a third inductor, connected in parallel between an output terminal of said transistor and said output terminal of said analog amplifier circuit; and

a second series resonance circuit having a fourth capacitor and a fourth inductor, connected in series between said output terminal of said analog amplifier circuit and the ground;

wherein said first and second parallel resonance circuits capacitively function with respect to both of a first frequency and a second frequency which is different from said first frequency, and said first and second series resonance circuits inductively function with respect to said first frequency while said first and second series resonance circuits capacitively function with respect to said second frequency.

20. Analog amplifier circuit having a transistor serving as an amplifier, an input matching circuit thereof and an output matching circuit thereof, an input terminal of said analog amplifier circuit and an output terminal of said analog amplifier circuit, said input matching circuit comprising:

a first parallel resonance circuit having a first capacitor and a first inductor, connected in parallel between an input terminal of said transistor and the ground; and

a first series resonance circuit having a second capacitor and a second inductor, connected in series between said input terminal of said transistor and said input terminal of said analog amplifier circuit;

said output matching circuit comprising:

a second parallel resonance circuit having a third capacitor and a third inductor, connected in parallel between an output terminal of said transistor and the ground; and

a second series resonance circuit having a fourth capacitor and a fourth inductor, connected in series between said output terminal of said transistor and said output terminal of said analog amplifier circuit;

wherein said first and second parallel resonance circuits inductively function with respect to a first frequency while said first and second parallel resonance circuits capacitively function with respect to a second frequency which is different from said first frequency, so as to perform impedance matching with respect to said first frequency and said second frequency.

21. Circuit according to claim 20,
wherein said first and second series resonance circuits capacitively function with respect to said first frequency while said first and second series resonance circuits inductively function with respect to said second frequency.

22. Analog amplifier circuit having a transistor serving as an amplifier, an input matching circuit thereof and an output matching circuit thereof, an input terminal of said analog amplifier circuit and an output terminal of said analog amplifier circuit,

said input matching circuit comprising:

a first parallel resonance circuit having a first capacitor and a first inductor, connected in parallel between an input terminal of said transistor and the ground; and
a first series resonance circuit having a second capacitor and a second inductor, connected in series between said input terminal of said transistor and said input terminal of said analog amplifier circuit;

said output matching circuit comprising:

a second parallel resonance circuit having a third capacitor and a third inductor, connected in parallel between an output terminal of said transistor and the ground; and
a second series resonance circuit having a fourth capacitor and a fourth inductor, connected in series between said output terminal of said transistor and said output terminal of said analog amplifier circuit;

wherein said first and second parallel resonance circuits inductively function with respect to both of a first frequency and a second frequency which is different from said first frequency, and said first and second series resonance circuits capacitively function with respect to said first frequency while said first and second series resonance circuits inductively function with respect to said second frequency.

23. Analog amplifier circuit having a transistor serving as an amplifier, an input matching circuit thereof and an output matching circuit thereof, an input terminal of said analog amplifier circuit and an output terminal of said analog amplifier circuit,

said input matching circuit comprising:

a first parallel resonance circuit having a first capacitor and a first inductor, connected in parallel between an input terminal of said transistor and the ground; and
a first series resonance circuit having a second capacitor and a second inductor, connected in series between said input terminal of said transistor and said said input terminal of said analog amplifier circuit;

said output matching circuit comprising:

a second parallel resonance circuit having a third capacitor and a third inductor, connected in parallel between an output terminal of said transistor and the ground; and
a second series resonance circuit having a fourth capacitor and a fourth inductor, connected in series between said output terminal of said transistor and said output terminal of said analog amplifier circuit;

wherein said first and second series resonance circuits capacitively function with respect to both of a first frequency and a second frequency which is different from said first frequency, and said first and second series resonance circuits capacitively function with respect to said first frequency while said first and second series resonance circuits inductively function with respect to said second frequency.

24. Analog amplifier circuit having a transistor serving as an amplifier, an input matching circuit thereof and an output matching circuit thereof, an input terminal of said analog amplifier circuit and an output terminal of said analog amplifier circuit,

said input matching circuit comprising:

a first series resonance circuit having a first capacitor and a first inductor, connected in series between said input terminal of said transistor and the ground; and
a first parallel resonance circuit having a second capacitor and a second inductor, connected in parallel between an input terminal of said transistor and said input terminal of said analog amplifier circuit;

said output matching circuit comprising:

a second series resonance circuit having a third capacitor and a third inductor, connected in series between said output terminal of said transistor and the ground; and
a second parallel resonance circuit having a fourth capacitor and a fourth inductor, connected in parallel between an output terminal of said transistor and said output terminal of said analog amplifier circuit;

wherein said first and second series resonance circuits capacitively function with respect to a first frequency while said first and second series resonance circuits inductively function with respect to a second frequency which is different from said first frequency, so as to perform impedance matching with respect to said first frequency and said second frequency.

25. Circuit according to claim 24,
wherein said first and second parallel resonance circuits inductively function with respect to said first frequency while said first and second parallel resonance circuits capacitively function with respect to said second frequency.

26. Analog amplifier circuit having a transistor serving as an amplifier, an input matching circuit thereof and an output matching circuit thereof, an input terminal of said analog amplifier circuit and an output terminal of said analog amplifier circuit,
said input matching circuit comprising:

a first series resonance circuit having a first capacitor and a first inductor, connected in series between said input terminal of said transistor and the ground; and
a first parallel resonance circuit having a second capacitor and a second inductor, connected in parallel between an input terminal of said transistor and said input terminal of said analog amplifier circuit;

said output matching circuit comprising:

a second series resonance circuit having a third capacitor and a third inductor, connected in series between said output terminal of said transistor and the ground; and
a second parallel resonance circuit having a fourth capacitor and a fourth inductor, connected in parallel between an output terminal of said transistor and said output terminal of said analog amplifier circuit;

wherein said first and second series resonance circuits inductively function with respect to both of a first frequency and a second frequency which is different from said first frequency, and said first and second parallel resonance circuits capacitively function with respect to said first frequency while said first and second parallel resonance circuits inductively function with respect to said second frequency.

27. Analog amplifier circuit having a transistor serving as an amplifier, an input matching circuit thereof and an output matching circuit thereof, an input terminal of said analog amplifier circuit and an output terminal of said analog amplifier circuit,
said input matching circuit comprising:

a first series resonance circuit having a first capacitor and a first inductor, connected in series between said input terminal of said transistor and the ground; and
a first parallel resonance circuit having a second capacitor and a second inductor, connected in parallel between an input terminal of said transistor and said input terminal of said analog amplifier circuit;

said output matching circuit comprising:

a second series resonance circuit having a third capacitor and a third inductor, connected in series between said output terminal of said transistor and the ground; and
a second parallel resonance circuit having a fourth capacitor and a fourth inductor, connected in parallel between an output terminal of said transistor and said output terminal of said analog amplifier circuit;

wherein said first and second series resonance circuits capacitively function with respect to both of a first frequency and a second frequency which is different from said first frequency, and said first and second parallel resonance circuits capacitively function with respect to said first frequency while said first and second parallel resonance circuits inductively function with respect to said second frequency.

28. Analog amplifier circuit having a transistor serving as an amplifier, an input matching circuit thereof and an output matching circuit thereof for performing impedance matching with respect to a first frequency and a second frequency which is different from said first frequency, an input terminal of said analog amplifier circuit and an output terminal of said analog amplifier circuit,
said input matching circuit comprising:

a first phase rotating element, one end of which being connected to said input terminal of said transistor, for rotating a phase of an input signal; and
a first resonance circuit, one end of which being connected to said input terminal of said analog amplifier circuit and the other end thereof being connected to the other end of said first phase rotating element;

said output matching circuit comprising:

a second phase rotating element, one end of which being connected to said output terminal of said transistor, for rotating a phase of an output signal of said transistor; and
a second resonance circuit, one end of which being connected to said output terminal of said analog amplifier circuit and the other end thereof being connected to the other end of said second phase rotating element.

29. Analog amplifier circuit having a transistor serving as an amplifier, an input matching circuit thereof and an output matching circuit thereof for performing impedance matching with respect to a first frequency and a second frequency which is different from said first frequency, an input terminal of said analog amplifier circuit and an output terminal of said analog amplifier circuit,

said input matching circuit comprising:

a first phase rotating element, one end of which being connected to said input terminal of said transistor, the other end thereof being connected to said input terminal of said analog amplifier circuit, for rotating a phase of an input signal; and
a first resonance circuit, one end of which being connected to said input terminal of said analog amplifier circuit and the other end thereof being connected to the ground;

said output matching circuit comprising:

a second phase rotating element, one end of which being connected to said output terminal of said transistor, the other end thereof being connected to said output terminal of said analog amplifier circuit, for rotating a phase of an output signal of said transistor; and
a second resonance circuit, one end of which being connected to said output terminal of said analog amplifier circuit and the other end thereof being connected to the ground.

# FIG. 1

EP 1 235 345 A2

# FIG. 2A

# FIG. 2B

# FIG. 2C

## FIG. 3

# FIG. 4

# FIG. 5A

# FIG. 5B

# FIG. 5C

## FIG. 6

FIG. 7A

FIG. 7B

FIG. 7C

FIG. 8

FIG. 9

## FIG. 10A

## FIG. 10B

## FIG. 10C

FIG. 11

# FIG. 12

# FIG. 13

# FIG. 14

# FIG. 15

## PRIOR ART